# EUROPEAN PATENT APPLICATION

(11) **EP 4 811 420 A1**
(43) Date of publication of application: **23.09.2026**
(21) Application number: 24905943.7
(22) Date of filing: 14.11.2024
(51) Int. Cl.: H01L 21/28, H01L 21/04, H01L 23/48

(54) **SEMICONDUCTOR DEVICE, MANUFACTURING METHOD THEREFOR, AND ELECTRONIC APPARATUS**

(30) Priority: 20.12.2023 CN 202311770127
(71) Applicant: Huawei Technologies Co., Ltd., Shenzhen, Guangdong 518129 (CN)
(72) Inventor: WEI, Xing, Shenzhen, Guangdong 518129 (CN); LI, Shuiming, Shenzhen, Guangdong 518129 (CN); LU, An, Shenzhen, Guangdong 518129 (CN); ZHANG, Guofeng, Shenzhen, Guangdong 518129 (CN); ZHANG, Zhili, Shenzhen, Guangdong 518129 (CN); LI, Haijun, Shenzhen, Guangdong 518129 (CN)
(74) Representative: Isarpatent
(86) International application number: PCT/CN2024/132014
(87) International publication number: WO 2025/130457

(57) **Abstract**

This application provides a semiconductor device, a manufacturing method thereof, and an electronic device. The semiconductor device includes: a channel layer, a barrier layer, a first dielectric layer, a second dielectric layer, a gate, and a field plate; the first dielectric layer is deployed with a first through via and a second through via that penetrate the first dielectric layer; the gate is disposed between the barrier layer and the second dielectric layer and is connected to the barrier layer through the first through via; the second through via is filled with the second dielectric layer, so that a groove is formed at a position that is on a surface of the second dielectric layer and that is corresponding to the second through via; and the groove is filled with the field plate. In this way, the groove can be correspondingly formed, through filling, on a surface of a side that is of the second dielectric layer and that faces away from a substrate, and the groove is deployed corresponding to the second through via, so that during formation of the groove, the second through via is filled to naturally form the groove without etching the second dielectric layer. This simplifies the manufacturing process of the semiconductor device and reduces manufacturing difficulty, thereby reducing manufacturing costs and helping improve the manufacturing yield of the semiconductor device.

## Description

### CROSS-REFERENCE TO RELATED APPLICATIONS

This application claims priority to Chinese Patent Application No. 202311770127.7, filed with the China National Intellectual Property Administration on December 20, 2023 and entitled "SEMICONDUCTOR DEVICE, MANUFACTURING METHOD THEREOF, AND ELECTRONIC DEVICE", which is incorporated herein by reference in its entirety.

### TECHNICAL FIELD

This application relates to the field of semiconductor technologies, and in particular, to a semiconductor device, a manufacturing method thereof, and an electronic device.

### BACKGROUND

A transistor used as a semiconductor device usually includes: a substrate, and a channel layer, a barrier layer, a first dielectric layer, a second dielectric layer, and a third dielectric layer that are sequentially located on the substrate, where the first dielectric layer is deployed with a first through via, and a gate disposed between the second dielectric layer and the barrier layer is connected to the barrier layer through the first through via; and the second dielectric layer is deployed with a second through via, and the second through via is filled with a field plate disposed between the second dielectric layer and the third dielectric layer, so that a part of the field plate filled in the second through via is referred to as a recess portion. The transistor further includes a third through via and a fourth through via that separately penetrate the third dielectric layer, the second dielectric layer, and the first dielectric layer, where the source is connected to a source region in the barrier layer through the third through via, the drain is connected to a drain region in the barrier layer through the fourth through via, the recess portion is disposed between the gate and the drain, and the field plate is connected to the source. Electric field distribution between the gate and the drain can be adjusted through the recess portion, thereby reducing a parasitic capacitance between the gate and the drain, and improving performance of the transistor.

However, to form the second through via in the second dielectric layer for creating the recess portion, the second dielectric layer needs to be etched. In this case, etching needs to avoid a position of the first through via so as to prevent adverse impacts on the gate. This requires high etching accuracy during etching. In addition, when etch selectivity between manufacturing materials of the first dielectric layer and the second dielectric layer is small, over-etching is prone to occur during etching of the second dielectric layer. This may easily damage the barrier layer, thereby degrading the performance of the transistor, increasing the manufacturing difficulty of the transistor, and reducing the manufacturing yield.

### SUMMARY

This application provides a semiconductor device, a manufacturing method thereof, and an electronic device, to reduce the manufacturing difficulty of the semiconductor device, reduce manufacturing costs, and improve the manufacturing yield of the semiconductor device.

According to a first aspect, an embodiment of this application provides a semiconductor device. The semiconductor device may include a channel layer, a barrier layer, a first dielectric layer, and a second dielectric layer that are sequentially stacked, and the first dielectric layer is deployed with a first through via and a second through via that penetrate the first dielectric layer. The semiconductor device further includes a gate and a field plate, the gate is disposed between the barrier layer and the second dielectric layer, the gate is connected to the barrier layer through the first through via, the second through via is filled with the second dielectric layer, so that a groove is formed at a position that is on a surface of the second dielectric layer and that is corresponding to the second through via, the field plate is disposed on a surface of a side that is of the second dielectric layer and that faces away from the first dielectric layer, and the groove is filled with the field plate.

In this way, when the second through via is filled with the second dielectric layer, the groove is correspondingly formed on the surface of the side that is of the second dielectric layer and that faces away from a substrate, the groove is deployed corresponding to the second through via, and a shape of the groove is similar to that of the second through via, so that during formation of the groove, the second through via is filled to naturally form the groove without etching the second dielectric layer. This simplifies the manufacturing process of the semiconductor device and reduces manufacturing difficulty, thereby reducing manufacturing costs and helping improve the manufacturing yield of the semiconductor device.

In addition, when the groove is filled with the field plate, a part of the field plate filled in the groove may be referred to as a recess portion, and a part of the field plate disposed outside the groove may be referred to as a body, so that the body and the recess portion form the field plate. In this case, the groove is formed, so that the recess portion of the field plate is naturally formed, to reduce a parasitic capacitance of the semiconductor device through the recess portion, thereby improving performance of the semiconductor device.

Optionally, the shape of the groove is similar to the shape of the second through via, and the field plate with which the groove is filled forms the recess portion. Therefore, a shape of the recess portion is the same as the shape of the groove, the shape of the recess portion is similar to the shape of the second through via, and the shape of the second through via may be set according to an actual requirement, for example, may be but is not limited to: a circular shape or another shape such as a quadrilateral shape. This is not specifically limited herein.

Optionally, the field plate extends in a first direction, a plurality of recess portions are deployed and spaced apart, and the recess portions are arranged in the first direction. In this way, when the semiconductor device includes the drain, and the recess portion is deployed in space between the gate and the drain, the plurality of recess portions are deployed between the gate and the drain, and electric field distribution between the gate and the drain can be adjusted through these recess portions, thereby reducing a parasitic capacitance between the gate and the drain. In addition, a plurality of grooves may be deployed and spaced apart. A quantity of deployed grooves may be the same as a quantity of deployed recess portions. In this case, the recess portions may be disposed in a one-to-one correspondence with the grooves, so that each recess portion can be naturally formed during filling of the groove, thereby reducing manufacturing difficulty of the recess portion, and simplifying the manufacturing process.

Alternatively, the field plate extends in the first direction, a groove is deployed and extends in the first direction, and the groove is fully filled with the recess portion. In this way, the quantity of deployed grooves can be reduced, and the quantity of deployed second through vias can be reduced. During formation of the first through via and the second through via, patterning needs to be performed on the first dielectric layer before etching. Therefore, simplifying a structure of the second through via can reduce difficulty of patterning, thereby reducing manufacturing difficulty of the semiconductor device. In addition, the recess portion extends to two opposite ends that are of the body (or the field plate) and that are disposed in the first direction. In other words, a length of the body in the first direction is equal to a length of the recess portion in the first direction. In this way, the field plate can be fully used to provide the recess portion between the gate and the drain, thereby further reducing a parasitic capacitance between the gate and the drain, and improving performance of the semiconductor device.

Optionally, the semiconductor device may further include a source and the drain. The semiconductor device may further include a third through via and a fourth through via that separately penetrate the second dielectric layer, the first dielectric layer, and the barrier layer. The source is connected to a source region in the channel layer through the third through via, and the drain is connected to a drain region in the channel layer through the fourth through via. The source, the drain, and the field plate are disposed on a same layer, and the source, the drain, and the field plate may be made of a same material. In this way, the source, the drain, and the field plate can be formed simultaneously by using one manufacturing process, so that the source, the drain, and the field plate are located on a same dielectric layer (namely, the second dielectric layer). Compared with a conventional technology in which the source, the drain, and the field plate are formed by using different manufacturing processes, so that the source, the drain, and the field plate are located on different dielectric layers, this further reduces manufacturing difficulty of the semiconductor device and simplifies the manufacturing process, to further reduce manufacturing costs of the semiconductor device.

The field plate is electrically connected to the source through a connecting portion, so that the recess portion in the field plate has a same electric potential as the source. When the recess portion is disposed between the gate and the drain, existence of the recess portion may adjust electric field distribution between the gate and the drain, thereby reducing a parasitic capacitance between the gate and the drain, and improving stability of the semiconductor device.

Optionally, a distance between a groove bottom of the groove and the barrier layer may be defined as a first distance, that is, a distance between the barrier layer and a surface that is of the recess portion and that faces the substrate may be defined as the first distance. A distance between the barrier layer and a surface of a side that is of the gate and that faces away from the barrier layer may be defined as a second distance, and the first distance may be set to be not greater than the second distance. If the surface of the side that is of the gate and that faces away from the barrier layer is referred to as an upper surface, the groove bottom is closer to the barrier layer than the upper surface. Therefore, the recess portion may be located in an area in which the gate is directly opposite to the drain in a second direction, so that electric field distribution between the gate and the drain can be effectively adjusted, to further reduce a parasitic capacitance between the gate and the drain. The first distance may be designed according to an actual requirement. This is not specifically limited herein. The second direction may be understood as a direction that is perpendicular to the first direction and parallel to a surface of the substrate.

In addition, during formation of the groove, the second through via is filled to naturally form the groove without etching the second dielectric layer. Therefore, a difference of thicknesses of the second dielectric layer at different positions is not greater than 500 nm. In other words, thicknesses of the second dielectric layer at different positions are close. In addition, the second dielectric layer is usually set to be thick, and the first dielectric layer is usually set to be thin. Therefore, a thickness of the second dielectric layer at any position is greater than a thickness of the first dielectric layer. In this way, a voltage withstand capability of one end that is of the field plate and that is close to the drain can be improved, to avoid a short circuit between the drain and the end that is of the field plate and that is close to the drain caused by breakdown when the second dielectric layer is thin, thereby improving reliability and safety of the semiconductor device. The thickness of the second dielectric layer may be set to 300 nm, and the thickness of the first dielectric layer may be set to 50 nm.

Optionally, a manner of setting a manufacturing material of each structure in the semiconductor device may include, but is not limited to, the following manner.

A manufacturing material of the channel layer may include but is not limited to GaN and the like.

A manufacturing material of the barrier layer may include but is not limited to a semiconductor material such as AlGaN, AlN, InGaN, or ScAlN.

A manufacturing material of the first dielectric layer may include but is not limited to a dielectric material such as AlN, SiN, Al₂O₃, or SiO₂.

A manufacturing material of the second dielectric layer may include but is not limited to a dielectric material such as AlN, SiN, Al₂O₃, or SiO₂, and the manufacturing material of the first dielectric layer may be the same as or different from that of the second dielectric layer.

A manufacturing material of the gate may include but is not limited to at least one of conductive materials such as Ni, TiN, W, and Pt.

Manufacturing materials of the source, the drain, and the field plate may include but are not limited to at least one of conductive materials such as Ti, Au, Al, and TiN.

The gate, the source, the drain, and the field plate may be of a multi-layer composite structure. The source is used as an example. The source may be set to be of the following structure: a composite structure formed through stacking of a Ti layer and an Au layer, a composite structure formed through sequential stacking of a Ti layer, an Al layer, and a Ti layer, a composite structure formed through sequential stacking of a TiN layer, an Al layer, and a TiN layer, or another composite structure such as a composite structure formed through sequential stacking of a TiN layer, a Ti layer, an Al layer, a Ti layer, and a TiN layer, which are not listed one by one herein.

According to a second aspect, an embodiment of this application further provides a semiconductor device manufacturing method. The manufacturing method is used to manufacture the semiconductor device described in the first aspect or any embodiment of the first aspect. The manufacturing method may include: forming a channel layer on a substrate; forming a barrier layer on the channel layer; forming a first dielectric layer on the barrier layer; forming a first through via and a second through via that penetrate the first dielectric layer; forming a gate on the first dielectric layer, where the gate is connected to the barrier layer through the first through via; forming a second dielectric layer on the first dielectric layer on which the gate is formed, where the second through via is filled with the second dielectric layer, so that a groove is formed at a position that is on a surface of the second dielectric layer and that is corresponding to the second through via; and forming a field plate on the second dielectric layer, where the groove is filled with the field plate. In this way, when the second through via is filled with the second dielectric layer, the groove is correspondingly formed on a surface of a side that is of the second dielectric layer and that faces away from a substrate, the groove is deployed corresponding to the second through via, and a shape of the groove is similar to that of the second through via, so that during formation of the groove, the second through via is filled to naturally form the groove without etching the second dielectric layer. This simplifies the manufacturing process of the semiconductor device and reduces manufacturing difficulty, thereby reducing manufacturing costs and helping improve the manufacturing yield of the semiconductor device.

Optionally, the manufacturing method may further include: after the second dielectric layer is formed and before the field plate is formed, separately etching the second dielectric layer, the first dielectric layer, and the barrier layer to form a third through via and a fourth through via, where the third through via exposes a source region in the channel layer, and the fourth through via exposes a drain region in the channel layer. Based on this, forming the field plate may specifically include: forming a source, a drain, and the field plate on the second dielectric layer, where the source is connected to the source region through the third through via, and the drain is connected to the drain region through the fourth through via. In this way, the source, the drain, and the field plate can be formed simultaneously by using one manufacturing process, so that the source, the drain, and the field plate are located on a same dielectric layer (namely, the second dielectric layer). Compared with a conventional technology in which the source, the drain, and the field plate are formed by using different manufacturing processes, so that the source, the drain, and the field plate are located on different dielectric layers, this further reduces manufacturing difficulty of the semiconductor device and simplifies the manufacturing process, to further reduce manufacturing costs of the semiconductor device.

It should be understood that a problem-resolving principle of the semiconductor device manufactured according to the manufacturing method is similar to that of the foregoing semiconductor device. Therefore, for implementation and technical effect of the manufacturing method, refer to the implementation and technical effect of the foregoing semiconductor device. No repeated description is provided herein.

According to a third aspect, an embodiment of this application further provides an electronic device. The electronic device may include a housing and the semiconductor device described in the first aspect or any embodiment of the first aspect, and the semiconductor device is disposed in the housing. In this way, on the basis of simplifying the manufacturing process of the semiconductor device and reducing manufacturing difficulty and manufacturing costs of the semiconductor device, the manufacturing process of the electronic device can also be simplified, and manufacturing difficulty and manufacturing costs of the electronic device can also be reduced.

It should be understood that a problem-resolving principle of the electronic device is similar to that of the foregoing semiconductor device. Therefore, for implementation and technical effect of the electronic device, refer to the implementation and technical effect of the foregoing semiconductor device. No repeated description is provided herein.

### BRIEF DESCRIPTION OF DRAWINGS

FIG. 1 is a diagram of a structure of an electronic device according to an embodiment of this application;
FIG. 2 is a diagram of a structure of a semiconductor device in the prior art;
FIG. 3 is a diagram of a structure of a semiconductor device according to an embodiment of this application;
FIG. 4 is a sectional view in a direction of x1-x2 in FIG. 3;
FIG. 5 is a sectional view in a direction of x3-x4 in FIG. 3;
FIG. 6 is another sectional view in a direction of x3-x4 in FIG. 3; and
FIG. 7A to FIG. 7F are a flowchart of manufacturing a semiconductor device according to an embodiment of this application.

### DESCRIPTION OF EMBODIMENTS

To make the objectives, technical solutions, and advantages of this application clearer, the following further describes this application in detail with reference to the accompanying drawings.

It should be noted that identical reference numerals in the accompanying drawings in this application indicate identical or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are merely used to illustrate a relative position relationship and do not represent an actual scale.

To facilitate understanding of the technical solutions provided in embodiments of this application, the following first describes an application scenario of the technical solutions.

The semiconductor device provided in embodiments of this application may be widely used in various electronic devices. The electronic device provided in embodiments of this application may include various terminal devices and electronic components. The terminal device may include but is not limited to devices such as a smartphone, a smart TV, a smart TV set-top box, a smartwatch, a personal computer (personal computer, PC), a wearable device, and a smart broadband. The electronic component may include but is not limited to a telecommunication device like a wireless network, a fixed network, or a server, and a component like a chip module or a memory. Details are not described herein.

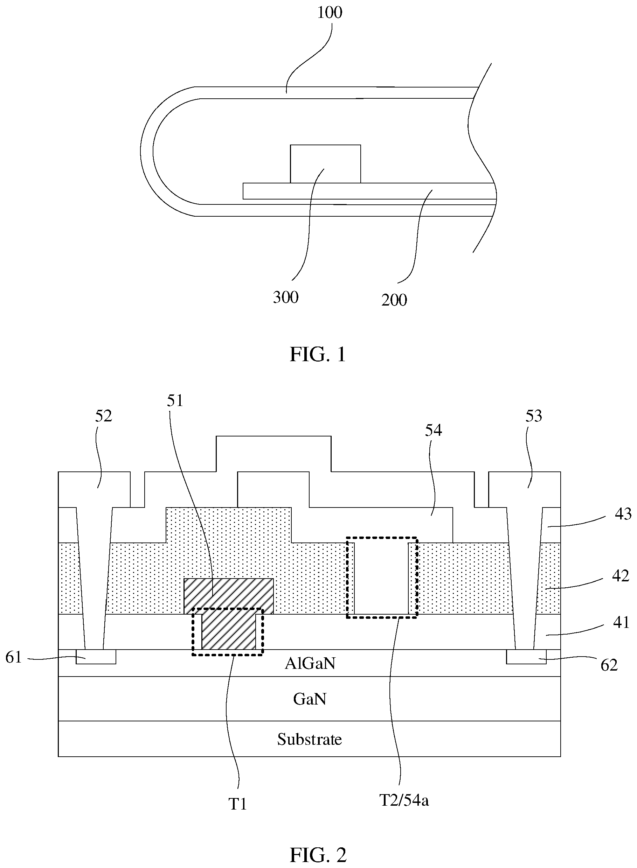

FIG. 1 is an example of a diagram of a structure of a semiconductor device used in an electronic device. As shown in FIG. 1, the electronic device includes a housing 100 and a circuit board 200 disposed in the housing 100. The semiconductor device 300 is disposed on the circuit board 200. The semiconductor device 300 is a core of the electronic device. With continuous development of technologies, higher requirements are imposed on energy consumption, power, efficiency, and miniaturization of the semiconductor device 300. Materials such as GaN, GaAs, SiC, Ga₂O₃, AlN, and diamond have a wide forbidden band, and have a significant advantage in applications of high power, high frequency, and the like. When the semiconductor device 300 is manufactured by using these materials, the semiconductor device 300 can meet performance requirements. However, for example, the semiconductor device 300 is a transistor, and there is a parasitic capacitance between a gate and a drain in the transistor. Existence of the parasitic capacitance may cause performance such as output power, a gain, and efficiency of the transistor to be limited, and consequently, performance of the transistor cannot be effectively improved.

To resolve this problem, a recess portion may be disposed in a field plate, and the recess portion is disposed between the gate and the drain, to reduce the parasitic capacitance between the gate and the drain, and improve performance of the transistor. Refer to FIG. 2. For example, a transistor includes a substrate, and a GaN layer, an AlGaN layer, a first dielectric layer 41, a second dielectric layer 42, and a third dielectric layer 43 that are sequentially located on the substrate. The transistor further includes: a gate 51, a source 52, a drain 53, and a field plate 54, where the first dielectric layer 41 is deployed with a first through via T1, and the gate 51 disposed between the second dielectric layer 42 and the AlGaN layer is connected to the AlGaN layer through the first through via T1. The second dielectric layer 42 is deployed with a second through via T2, and the second through via T2 is filled with the field plate 54 disposed between the second dielectric layer 42 and the third dielectric layer 43, so that a part of the field plate 54 filled in the second through via T2 is referred to as a recess portion 54a. The transistor further includes a third through via (not shown in FIG. 2) and a fourth through via (not shown in FIG. 2) that separately penetrate the third dielectric layer 43, the second dielectric layer 42, and the first dielectric layer 41. The source 52 is connected to a source region 61 in the AlGaN layer through the third through via, the drain 53 is connected to a drain region 62 in the AlGaN layer through the fourth through via, the recess portion 54a is disposed between the gate 51 and the drain 53, and the field plate 54 is connected to the source 52, which is not shown in FIG. 2. Electric field distribution between the gate 51 and the drain 53 may be adjusted through the recess portion 54a, thereby reducing a parasitic capacitance between the gate 51 and the drain 53. However, to form the second through via T2 in the second dielectric layer 42 for creating the recess portion 54a, the second dielectric layer 42 needs to be etched. In this case, etching needs to avoid a position of the first through via T1, to avoid an adverse impact on the gate 51. This requires high etching accuracy during etching. In addition, when etch selectivity between manufacturing materials of the first dielectric layer 41 and the second dielectric layer 42 is small, over-etching is prone to occur during etching of the second dielectric layer 42. This may easily damage the AlGaN layer, thereby degrading the performance of the transistor, increasing the manufacturing difficulty of the transistor, and reducing the manufacturing yield.

Embodiments of this application provide a semiconductor device, to reduce manufacturing difficulty of the semiconductor device, reduce manufacturing costs, and improve the manufacturing yield of the semiconductor device. The following provides description with reference to specific embodiments.

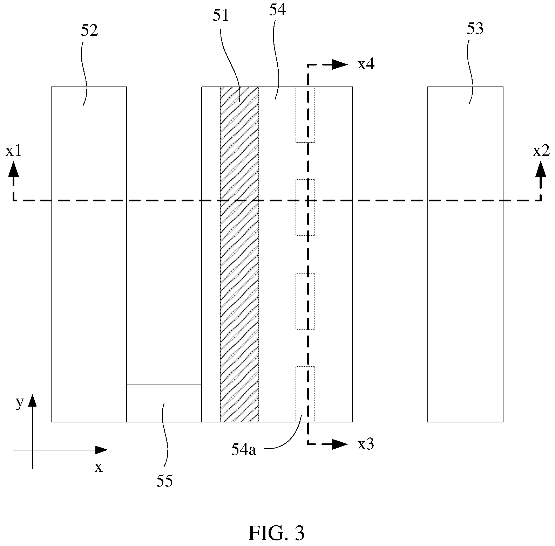

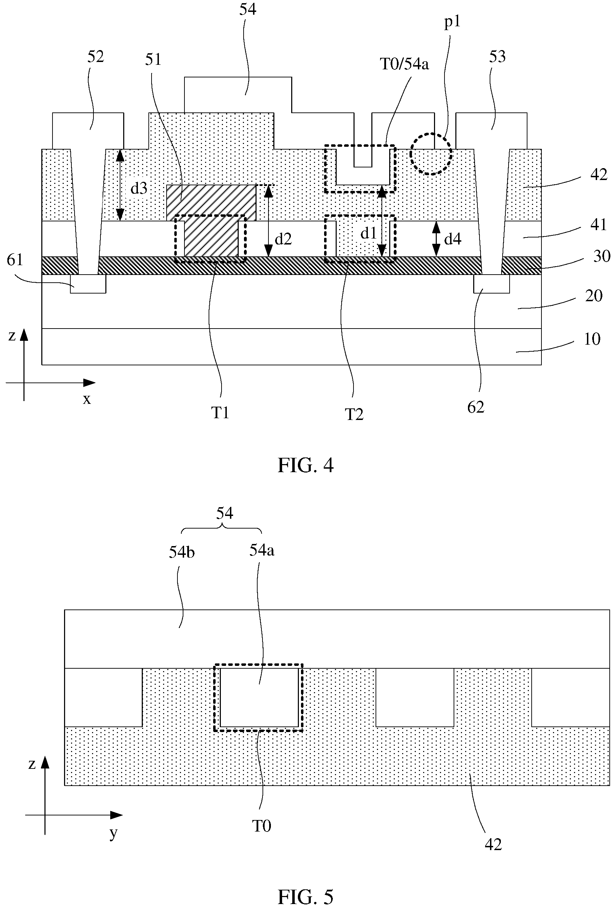

FIG. 3 to FIG. 5 are examples of diagrams of structures of a semiconductor device according to this application. Refer to FIG. 3 to FIG. 5. FIG. 4 is a sectional view in a direction of x1-x2 in FIG. 3. FIG. 5 is a sectional view in a direction of x3-x4 in FIG. 3. The semiconductor device includes: a substrate 10, and a channel layer 20, a barrier layer 30, a first dielectric layer 41, and a second dielectric layer 42 that are sequentially stacked on the substrate 10, where the first dielectric layer 41 is deployed with a first through via T1 and a second through via T2 that penetrate the first dielectric layer 41 in a thickness direction of the first dielectric layer 41. The semiconductor device may further include a gate 51 and a field plate 54. The gate 51 is disposed between the barrier layer 30 and the second dielectric layer 42, and the gate 51 is connected to the barrier layer 30 through the first through via T1. The second through via T2 is filled with the second dielectric layer 42, so that a groove T0 is formed at a position that is on a surface of the second dielectric layer 42 and that is corresponding to the second through via T2. In other words, when the second through via T2 is filled with the second dielectric layer 42, the groove T0 is correspondingly formed on a surface of a side that is of the second dielectric layer 42 and that faces away from the substrate 10, the groove T0 is deployed corresponding to the second through via T2, and a shape of the groove T0 is similar to that of the second through via T2, so that during formation of the groove T0, the second through via T2 is filled to naturally form the groove T0 without etching the second dielectric layer 42. This simplifies the manufacturing process of the semiconductor device and reduces manufacturing difficulty, thereby reducing manufacturing costs and helping improve the manufacturing yield of the semiconductor device. The field plate 54 is disposed on the surface of the side that is of the second dielectric layer 42 and that faces away from the first dielectric layer 41, and the groove T0 is filled with the field plate 54. In this case, a part of the field plate 54 filled in the groove T0 may be referred to as the recess portion 54a. Thus, by filling the groove T0, the recess portion 54a is naturally formed in the field plate 54, helping reduce a parasitic capacitance of the semiconductor device and improve performance of the semiconductor device.

The shape of the groove T0 is similar to the shape of the second through via T2, and the field plate 54 with which the groove T0 is filled forms the recess portion 54a. Therefore, a shape of the recess portion 54a is the same as the shape of the groove T0, the shape of the recess portion 54a is similar to the shape of the second through via T2, and the shape of the second through via T2 may be set according to an actual requirement, for example, may be but is not limited to: a circular shape or another shape such as a quadrilateral shape. This is not specifically limited herein.

Refer to FIG. 4. In addition, the semiconductor device may further include a source 52 and the drain 53. The semiconductor device may further include a third through via (not shown in FIG. 4) and a fourth through via (not shown in FIG. 4) that separately penetrate the second dielectric layer 42, the first dielectric layer 41, and the barrier layer 30. The source 52 is connected to a source region 61 in the channel layer 20 through the third through via, and the drain 53 is connected to a drain region 62 in the channel layer 20 through the fourth through via. The source 52, the drain 53, and the field plate 54 are disposed on a same layer, and the source 52, the drain 53, and the field plate 54 may be made of a same material. In this way, the source 52, the drain 53, and the field plate 54 can be formed simultaneously by using one manufacturing process, so that the source 52, the drain 53, and the field plate 54 are located on a same dielectric layer (namely, the second dielectric layer 42). Compared with a conventional technology in which the source 52, the drain 53, and the field plate 54 are formed by using different manufacturing processes, so that the source 52, the drain 53, and the field plate 54 are located on different dielectric layers, this further reduces manufacturing difficulty of the semiconductor device and simplifies the manufacturing process, to further reduce manufacturing costs of the semiconductor device.

Refer to FIG. 3. In addition, the field plate 54 is electrically connected to the source 52 through a connecting portion 55, so that the recess portion 54a in the field plate 54 has a same electric potential as the source 52. When the recess portion 54a is disposed between the gate 51 and the drain 53, existence of the recess portion 54a may adjust electric field distribution between the gate 51 and the drain 53, thereby reducing a parasitic capacitance between the gate 51 and the drain 53, and improving stability of the semiconductor device.

Further, a distance between a groove bottom of the groove T0 and the barrier layer 30 may be defined as a first distance d1, that is, a distance between the barrier layer 30 and a surface that is of the recess portion 54a and that faces the substrate 10 may be defined as the first distance d1. A distance between the barrier layer 30 and a surface of a side that is of the gate 51 and that faces away from the barrier layer 30 may be defined as a second distance d2, and the first distance d1 may be set to be not greater than the second distance d2. If the surface of the side that is of the gate 51 and that faces away from the barrier layer 30 is referred to as an upper surface, the groove bottom is closer to the barrier layer 30 than the upper surface. Therefore, the recess portion 54a may be located in an area in which the gate 51 is directly opposite to the drain 53 in the x direction, so that electric field distribution between the gate 51 and the drain 53 can be effectively adjusted, to further reduce a parasitic capacitance between the gate 51 and the drain 53. The first distance d1 may be designed according to an actual requirement. This is not specifically limited herein.

Refer to FIG. 3 and FIG. 5. The field plate 54, the source 52, the drain 53, and the gate 51 all extend in a first direction (namely, a y direction). The field plate 54 includes a body 54b and the recess portion 54a that are connected. The recess portion 54a is located in the groove T0, and the body 54b is located in an area outside the groove T0. The recess portion 54a and the body 54b may be integrally disposed. A plurality of recess portions 54a are deployed and spaced apart, and the recess portions 54a are arranged in the first direction. In this way, the plurality of recess portions 54a are deployed between the gate 51 and the drain 53, and electric field distribution between the gate 51 and the drain 53 can be reduced through these recess portions 54a, thereby reducing a parasitic capacitance between the gate 51 and the drain 53. In addition, a plurality of grooves T0 may be deployed and spaced apart. A quantity of deployed grooves T0 may be the same as a quantity of deployed recess portions 54a. In this case, the recess portions 54a may be disposed in a one-to-one correspondence with the grooves T0, so that each recess portion 54a can be naturally formed during filling of the groove T0, thereby reducing manufacturing difficulty of the recess portion 54a and simplifying the manufacturing process.

Still refer to FIG. 4. During formation of the groove T0, the second through via T2 is filled to naturally form the groove T0 without etching the second dielectric layer 42. Therefore, a difference of thicknesses of the second dielectric layer 42 at different positions is not greater than 500 nm. In other words, thicknesses of the second dielectric layer 42 at different positions are close. In addition, the second dielectric layer 42 is usually set to be thick, and the first dielectric layer 41 is usually set to be thin. Therefore, a thickness of the second dielectric layer 42 at any position is greater than a thickness of the first dielectric layer 41. In this way, a voltage withstand capability of one end (as shown in a dashed circle p1 in FIG. 4) that is of the field plate 54 and that is close to the drain 53 can be improved, to avoid a short circuit between the drain 53 and the end that is of the field plate 54 and that is close to the drain 53 caused by breakdown when the second dielectric layer 42 is thin, thereby improving reliability and safety of the semiconductor device. The thickness d3 of the second dielectric layer 42 may be set to 300 nm, and the thickness d4 of the first dielectric layer 41 may be set to 50 nm.

It should be understood that, with reference to FIG. 4, in the x direction, a distance between a right end of the field plate 54 and the drain 53 is usually at a micron level, and thicknesses of the second dielectric layer 42 and the first dielectric layer 41 are usually at a nanometer level. Therefore, a position circled by the dashed circle p1 in the field plate 54 is closer to the drain 53. If the second dielectric layer 42 is set to be thin, a breakdown withstand capability of the second dielectric layer 42 is low, and consequently, a short circuit between the drain 53 and the position circled by the dashed circle p1 in the field plate 54 is caused. Therefore, the second dielectric layer 42 is set to be thick, to improve a voltage and breakdown withstand capability of the second dielectric layer 42, thereby improving reliability and safety of the semiconductor device.

For example, a manner of setting a manufacturing material of each structure in the semiconductor device may include, but is not limited to, the following manner.

A manufacturing material of the channel layer 20 may include but is not limited to GaN and the like.

A manufacturing material of the barrier layer 30 may include but is not limited to a semiconductor material such as AlGaN, AlN, InGaN, or ScAlN.

A manufacturing material of the first dielectric layer 41 may include but is not limited to a dielectric material such as AlN, SiN, Al₂O₃, or SiO₂.

A manufacturing material of the second dielectric layer 42 may include but is not limited to a dielectric material such as AlN, SiN, Al₂O₃, or SiO₂, and the manufacturing material of the first dielectric layer 41 may be the same as or different from that of the second dielectric layer 42.

A manufacturing material of the gate 51 may include but is not limited to at least one of conductive materials such as Ni, TiN, W, and Pt.

Manufacturing materials of the source 52, the drain 53, and the field plate 54 may include but are not limited to at least one of conductive materials such as Ti, Au, Al, and TiN.

The gate 51, the source 52, the drain 53, and the field plate 54 may be of a multi-layer composite structure. The source 52 is used as an example. The source 52 may be set to be of the following structure: a composite structure formed through stacking of a Ti layer and an Au layer, a composite structure formed through sequential stacking of a Ti layer, an Al layer, and a Ti layer, a composite structure formed through sequential stacking of a TiN layer, an Al layer, and a TiN layer, or another composite structure such as a composite structure formed through sequential stacking of a TiN layer, a Ti layer, an Al layer, a Ti layer, and a TiN layer, which are not listed one by one herein.

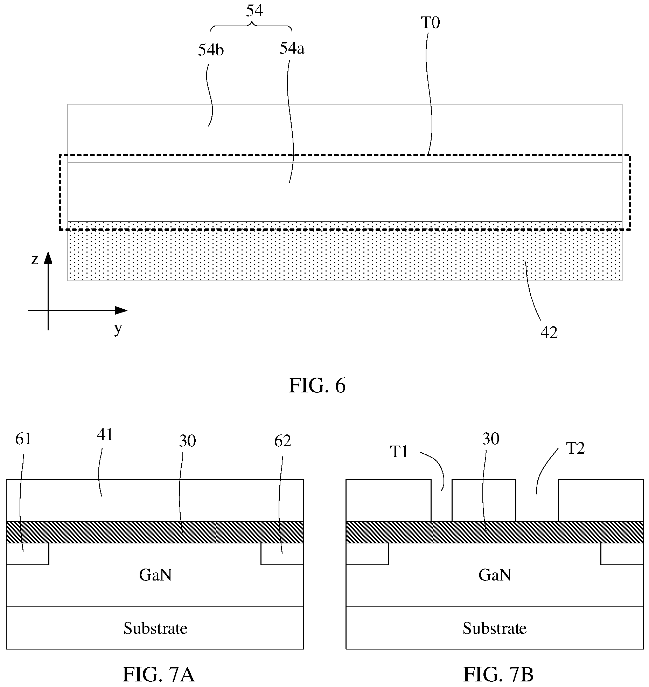

FIG. 6 is an example of a diagram of a structure of a semiconductor device according to this application. Refer to FIG. 6. A structure of the semiconductor device in this embodiment is basically similar to the structure of the semiconductor device shown in FIG. 3 to FIG. 5 in the foregoing embodiments, and a difference lies in that a recess portion 54a and a groove T0 are disposed. For example, when the field plate 54 extends in the first direction (namely, the y direction), a groove T0 is deployed and extends in the y direction, and the groove T0 is fully filled with the recess portion 54a, so that a part of field plate 54 filled in the groove T0 forms the recess portion 54a, and a part of field plate 54 located outside the groove T0 forms the body 54b. In this way, the quantity of deployed grooves T0 can be reduced, so that the quantity of deployed second through vias is reduced. During formation of the first through via and the second through via, patterning needs to be performed on the first dielectric layer before etching. Therefore, simplifying a structure of the second through via can reduce difficulty of patterning, thereby reducing manufacturing difficulty of the semiconductor device. In addition, the recess portion 54a extends to two opposite ends that are of the body 54b and that are disposed in the y direction. In other words, a length of the body 54b in the y direction is equal to a length of the recess portion 54a in the y direction. In this way, the field plate 54 can be fully used to provide the recess portion 54a between the gate 51 and the drain 53, thereby further reducing a parasitic capacitance between the gate 51 and the drain 53, and improving performance of the semiconductor device.

It should be understood that, for similarities between the structure of the semiconductor device in this embodiment and the structure of the semiconductor device shown in FIG. 3 to FIG. 5 in the foregoing embodiments, refer to related descriptions of the semiconductor device shown in FIG. 3 to FIG. 5 in the foregoing embodiments. No repeated description is provided herein.

FIG. 7A to FIG. 7F are an example of a diagram of a semiconductor device manufacturing method according to this application. Refer to FIG. 7A to FIG. 7F. The semiconductor device manufacturing method may include the following steps.

Step S1: As shown in FIG. 7A, grow a GaN layer epitaxially on the substrate by using but not limited to a physical vapor deposition method and by using but not limited to GaN, where the GaN layer may be used as the channel layer; and then grow an AlGaN layer epitaxially on the GaN layer by using but not limited to the physical vapor deposition method and by using but not limited to AlGaN, where the AlGaN layer may be used as the barrier layer 30.

Step S2: As shown in FIG. 7A, perform Si ion implantation by using an ion implantation method, to form the source region 61 and the drain region 62 in the GaN layer.

It should be noted that, during Si ion implantation, Si ions are also implanted into the AlGaN layer, which is not shown in FIG. 7A. However, because an ion implantation position is subsequently etched away to expose the source region 61 and the drain region 62, an ion implantation position in the AlGaN layer has little impact on the source region 61 and the drain region 62 in the GaN layer.

Step S3: As shown in FIG. 7A, form a SiO₂ layer on the barrier layer 30 by using but not limited to the physical vapor deposition method and by using but not limited to SiO₂, where the SiO₂ layer is used as the first dielectric layer 41.

Step S4: As shown in FIG. 7B, etch the SiO₂ layer to obtain, through etching, the first through via T1 and the second through via T2, where both the first through via T1 and the second through via T2 penetrate the SiO₂ layer to expose the barrier layer 30.

Certainly, during formation of the first through via T1 and the second through via T2, the first through via T1 and the second through via T2 may be formed simultaneously by using one etching process, or may be formed respectively by using two etching processes.

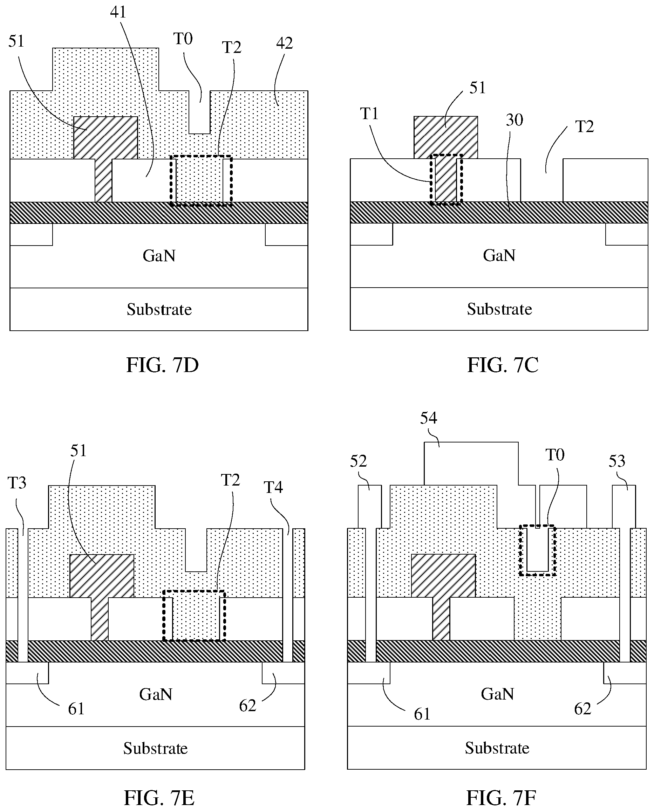

Step S5: As shown in FIG. 7C, sequentially deposit a Ni layer and an Au layer on the SiO₂ layer by using but not limited to the physical vapor deposition method and by using but not limited to Ni and Au, so that the Ni layer and the Au layer form a first composite layer; and perform patterning and etching on the first composite layer sequentially, so that the first through via T1 is filled with a remaining structure and the remaining structure is in contact with the barrier layer 30, the second through via T2 is exposed, and in this case, the remaining structure may be used as the gate 51.

Step S6: As shown in FIG. 7D, form a SiN layer by using but not limited to the physical vapor deposition method and by using but not limited to SiN, where the SiN layer covers the gate 51 and the first dielectric layer 41, the second through via T2 is filled with the SiN layer, and in this case, the groove T0 is formed at a position, corresponding to the second through via T2, in a surface of the SiN layer due to filling of the second through via T2, so that the groove T0 is naturally formed without etching; and the SiN layer is used as the second dielectric layer 42.

Step S7: As shown in FIG. 7E, perform patterning and etching on the SiN layer, the SiO₂ layer, and the AlGaN layer to form the third through via T3 and the fourth through via T4 that sequentially penetrate the SiN layer, the SiO₂ layer, and the AlGaN layer, where both the gate 51 and the second through via T2 are disposed between the third through via T3 and the fourth through via T4, the third through via T3 exposes the source region 61 in the GaN layer, and the fourth through via T4 exposes the drain region 62 in the GaN layer.

Step S8: As shown in FIG. 7F, deposit a Ti layer and an Au layer on the SiN layer sequentially by using but not limited to the physical vapor deposition method and by using but not limited to Ti and Au, so that the Ti layer and the Au layer form a second composite layer; and sequentially perform patterning and etching on the second composite layer, so that a structure with which the groove T0 is filled and that is located above a part of the SiN layer is the field plate 54, a structure with which the third through via T3 is filled is the source 52, the source 52 is in contact with the source region 61 through the third through via T3, a structure with which the fourth through via T4 is filled is the drain 53, the drain 53 is in contact with the drain region 62 through the fourth through via T4, and the source 52 is connected to the field plate 54, to form the semiconductor device.

In this way, first, because the groove T0 in the second dielectric layer 42 is naturally formed instead of being formed through etching, an etching process can be reduced, to simplify a manufacturing step of the semiconductor device, reduce manufacturing costs, and avoid a problem of a reduced manufacturing yield caused by etching bias occurred when the groove T0 is formed through etching, thereby improving a manufacturing yield of the semiconductor device and stability of a manufacturing process. Second, when the SiO₂ layer is etched to form the first through via T1 and the second through via T2, because etch selectivity between the AlGaN layer and the SiO₂ layer is large, the AlGaN layer may be used as an etch stop layer, which is highly controllable and avoids damage to the GaN layer caused by over-etching during etching. In this way, a manufacturing yield of the semiconductor device can also be improved, and stability of a manufacturing process can also be improved. Third, the source 52, the drain 53, and the field plate 54 are formed simultaneously, which can simplify a manufacturing process of the semiconductor device and reduce manufacturing costs compared with forming the source 52, the drain 53, and the field plate 54 separately. Fourth, the part of the field plate 54 filled in the groove T0 is the recess portion, and the recess portion may reduce a parasitic capacitance between the gate 51 and the drain 53, thereby improving performance of the semiconductor device.

It is clear that a person skilled in the art can make various modifications and variations to embodiments of this application without departing from the spirit and scope of embodiments of this application. This application is intended to cover these modifications and variations of embodiments of this application provided that they fall within the scope of protection defined by the following claims and their equivalent technologies.

## Claims

1. A semiconductor device, comprising: a channel layer, a barrier layer, a first dielectric layer, and a second dielectric layer that are sequentially stacked, wherein the first dielectric layer is deployed with a first through via and a second through via that penetrate the first dielectric layer; and
the semiconductor device further comprises a gate and a field plate, the gate is disposed between the barrier layer and the second dielectric layer, the gate is connected to the barrier layer through the first through via, the second through via is filled with the second dielectric layer, so that a groove is formed at a position that is on a surface of the second dielectric layer and that is corresponding to the second through via, the field plate is disposed on a surface of a side that is of the second dielectric layer and that faces away from the first dielectric layer, and the groove is filled with the field plate.

2. The semiconductor device according to claim 1, wherein the field plate extends in a first direction;
a part of the field plate filled in the groove is a recess portion; and
a plurality of recess portions are deployed and spaced apart, and the recess portions are arranged in the first direction.

3. The semiconductor device according to claim 2, wherein a plurality of grooves are deployed, and the grooves are spaced apart.

4. The semiconductor device according to claim 1, wherein the field plate extends in a first direction;
a part of the field plate filled in the groove is a recess portion; and
a groove is deployed and extends in the first direction, and the groove is fully filled with the recess portion.

5. The semiconductor device according to claim 4, wherein the recess portion extends to two opposite ends that are of the field plate and that are disposed in the first direction.

6. The semiconductor device according to any one of claims 1 to 5, wherein the semiconductor device further comprises a source and a drain;
the semiconductor device further comprises a third through via and a fourth through via that separately penetrate the second dielectric layer, the first dielectric layer, and the barrier layer, the source is connected to a source region in the channel layer through the third through via, and the drain is connected to a drain region in the channel layer through the fourth through via; and
the source, the drain, and the field plate are disposed on a same layer.

7. The semiconductor device according to any one of claims 1 to 6, wherein a distance between the groove bottom of the groove and the barrier layer is a first distance, a distance between the barrier layer and a surface of a side that is of the gate and that faces away from the barrier layer is a second distance, and the first distance is not greater than the second distance.

8. The semiconductor device according to any one of claims 1 to 7, wherein a difference of thicknesses of the second dielectric layer at different positions is not greater than 500 nm.

9. The semiconductor device according to any one of claims 1 to 8, wherein a thickness of the second dielectric layer at any position is greater than a thickness of the first dielectric layer.

10. A semiconductor device manufacturing method, comprising:
forming a channel layer on a substrate;
forming a barrier layer on the channel layer;
forming a first dielectric layer on the barrier layer;
forming a first through via and a second through via that penetrate the first dielectric layer;
forming a gate on the first dielectric layer, wherein the gate is connected to the barrier layer through the first through via;
forming a second dielectric layer on the first dielectric layer on which the gate is formed, wherein the second through via is filled with the second dielectric layer, so that a groove is formed at a position that is on a surface of the second dielectric layer and that is corresponding to the second through via; and
forming a field plate on the second dielectric layer, wherein the groove is filled with the field plate.

11. The manufacturing method according to claim 10, further comprising: after the second dielectric layer is formed and before the field plate is formed, separately etching the second dielectric layer, the first dielectric layer, and the barrier layer to form a third through via and a fourth through via, wherein the third through via exposes a source region in the channel layer, and the fourth through via exposes a drain region in the channel layer; and
forming the field plate specifically comprises: forming a source, a drain, and the field plate on the second dielectric layer simultaneously, wherein the source is connected to the source region through the third through via, and the drain is connected to the drain region through the fourth through via.

12. An electronic device, comprising a housing and the semiconductor device according to any one of claims 1 to 9, wherein the semiconductor device is disposed in the housing.
